# NEW EUROPEAN PATENT SPECIFICATION

(11) **EP 0 739 252 B2**
(45) Date of publication and mention of the opposition decision: **06.10.2004**
(45) Mention of the grant of the patent: 04.08.1999
(21) Application number: 94929958.0
(22) Date of filing: 22.09.1994
(51) Int. Cl.: B08B 3/00, B08B 3/04, B08B 3/12, B08B 5/00, B08B 7/02

(54) **PROCESS AND APPARATUS FOR THE TREATMENT OF SEMICONDUCTOR WAFERS IN A FLUID**
VERFAHREN UND VORRICHTUNG ZUR BEHANDLUNG EINER HALBLEITERSCHEIBE IN EINER FLÜSSIGKEIT
PROCEDE ET APPAREIL DE TRAITEMENT DE TRANCHES DE SEMI-CONDUCTEURS DANS UN FLUIDE

(30) Priority: 22.09.1993 US 124251
(43) Date of publication of application: 30.10.1996
(73) Proprietor: Legacy Systems, Inc., Richardson, TX 75080 (US)
(72) Inventor: MATTHEWS, Robert, Roger, Richmond, CA 94803 (US)
(74) Representative: VOSSIUS & PARTNER
(86) International application number: PCT/US1994/011080
(87) International publication number: WO 1995/008406

(56) References cited:
- EP-A- 0 385 536
- JP-A- 1 069 014
- US-A- 4 902 350
- US-A- 4 911 761
- US-A- 4 967 777
- US-A- 4 984 597
- US-A- 5 082 518
- US-A- 5 135 391
- US-A- 5 143 103
- US-A- 5 201 958

## Description

The present invention relates to semiconductor manufacturing. More specifically, the invention relates to a process for the solvent drying of the surfaces of objects such as semiconductor wafers after wet processing. The present invention also relates to an apparatus for carrying out this process.

In the fabrication of semiconductor wafers several process steps require contacting the wafers with fluids. Examples of such process steps include etching, photoresist stripping, and prediffusion cleaning. Often the chemicals utilized in these steps are quite hazardous in that they may comprise strong acids, alkalis, or volatile solvents.

The equipment conventionally used for contacting semiconductor wafers with process fluid consists of a series of tanks or sinks into which cassette loads of semiconductor wafers are dipped. Such conventional wet processing equipment poses several difficulties.

First, moving the wafers from tank to tank may result in contamination, which contamination is extremely detrimental to the microscopic circuits which the fabrication process creates. Second, the hazardous chemicals and deionized water which are used have to be regularly replaced with new solutions, usually introduced to the tank by bottle pour, chemical distribution or from building facilities in the case of deionized water. The chemicals generally are manufactured by chemical companies and shipped to the semiconductor manufacturing plant. The chemical purity is thus limited by the quality of the water used by the chemical manufacturers, by the container used for shipping and storing the chemical and by the handling of the chemical.

Moreover, as chemicals age, they can become contaminated with impurities from the air and from the wafers. The treatment of the last batch of wafers prior to fluid rejuvenation may not be as effective as treatment of the first batch of wafers in a new solution. Non-uniform treatment is a major concern in semiconductor manufacturing.

Some of the fluid contact steps of semiconductor manufacture include removal of organic materials and impurities from the wafer surface. For example, in the manufacture of integrated circuits, it is customary to bake a photoresist coating onto a silicon wafer as part of the manufacturing process. This coating of photoresist or organic material must be removed after processing.

US 4,902,350 discloses a method for cleaning, rinsing and drying thin wafers such as silicon wafers or other disc-like substrates or elements wherein the wafers are rinsed in a hot water bath while supported in a conventional slotted carrier. The wafers are cleaned and rinsed while being moved through a planar beam of sonic energy in a water bath. Drying of the wafers is achieved by slowly raising the wafers out of the water bath such that the water surface tension at the surface of the water bath evenly and effectively draws off water from the rinsing surfaces of the wafers. US 4,967,777 relates to an apparatus for treating an object with an aqueous liquid in which the object is immersed into the liquid in a tank which has overflow control members provided above faces of the tank with a predetermined space in an over-flow area for said liquid, said space being structured to lead the overflow of said liquid by capillary action.

A process is known from US 4,967,761 A and EP 0 385 536 A for organic solvent drying of treated semiconductor wafers, both documents recommending gaseous solvents that are miscible with water.

It is the object of this invention to provide a process for drying surfaces of objects such as semiconductor wafers wherein streaking or spotting on the wafer surface is minimized thus providing for a higher yield.

It is further an object of this invention to provide a drying process for the surfaces of objects such as semiconductor wafers wherein minimal mechanical stress is placed on the wafer, there is minimal contamination of the wafer and the wafer does not receive a static charge during drying.

It is yet a further object of this invention to provide a drying process for the surfaces of objects such as semiconductor wafers that does not require the generation, handling and reclamation of large amounts of organic vapor.

It is still further an object of this invention to provide a drying process for the surfaces of objects such as semiconductor wafers with reduced process time and reduced wafer handling.

The objects are achieved by the features of the claims.
Fig. 1 is a schematic diagram of a cross-section of a side view of an apparatus for the treatment of semiconductor wafers with fluid according to the present invention.
Fig. 2 is a schematic diagram of a cross-section of a front view of the tank of the present invention.
Fig. 3 is an exploded three-dimensional schematic diagram of a preferred embodiment of the gas diffuser of the present invention.
Figure 4 illustrates an apparatus for the solvent drying of a semiconductor wafer according to the present invention.

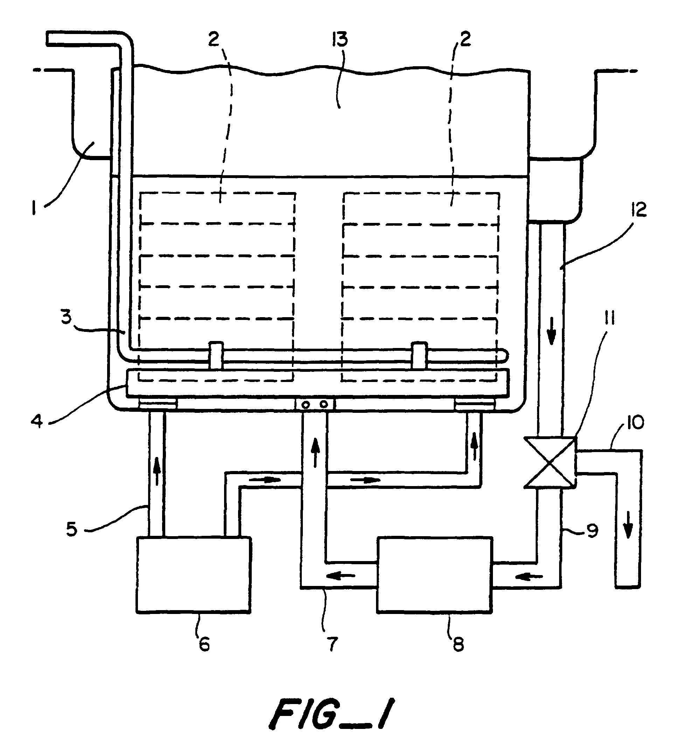

In a preferred embodiment, the process of the invention is conducted in the apparatus of Fig. 1. Processing takes place in a hooded, exhausted wet station, with proper ozone monitoring and catalytic destruct equipment in place. Resisted wafers or other wafers from which organic materials are to be removed are introduced into process tank 13 filled with subambient deionized water (1-15°C). The tank operates in a low flow (about 0.5 gpm) cascade mode, with water feed line 7 running through chiller 8 during processing in order to supply a continuous stream of chilled deionized water. Ozone from the ozone generator 6 is then diffused through conduit 5 into the tank through an in-situ diffuser 4. The resist strip is timed, after which the ozone is turned off and the wafers are rinsed by the continuous high flow (about 10-15 gpm) of deionized water. The drain line 12 is diverted to deionized water reclaim 10, and fresh deionized water is activated for the rinse. After a timed ambient deionized water rinse, the wafers may optionally receive a hot deionized water rinse.

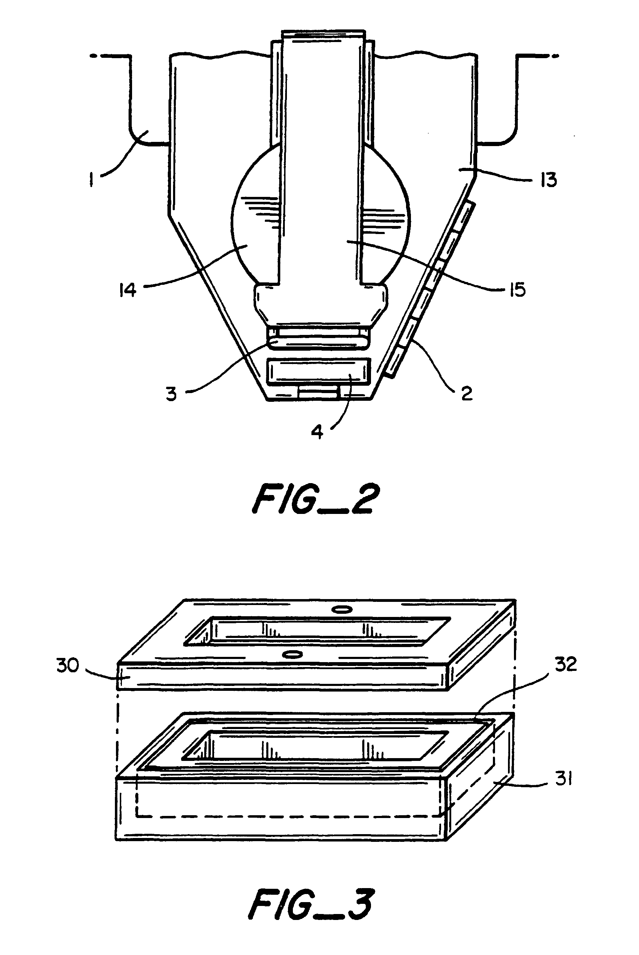

In a particularly preferred embodiment of the invention, the process is conducted in the tank of Fig. 2 which contains the gas diffuser of Fig. 3. However, although the apparatus of Fig. 1, the tank of Fig. 2 and the gas diffuser of Fig. 3 of the present invention are particularly preferred for use with the ozonated water process of the present invention, they may also be used for conducting any fluid treatment of semiconductor wafers. Specifically, previously known methods of removing organic materials from wafers may be used in the apparatus and tank of the invention. Applicant has found that the apparatus of the present invention can be used to efficiently carry out previously known processes without the need for multiple tanks. Moreover, the apparatus of the present invention provides the ability to generate chemicals in-situ, avoiding the problem of aging chemicals or transfer of hazardous chemicals from remote locations.

Tank 13 may also be fitted with ultraviolet light source 3 for subjecting the solution to UV radiation. The UV source can be mounted on the outside of the tank or, preferably, is submerged into the tank and placed over diffuser 4, as shown at 3 in Fig. 1 and Fig. 2. The UV light can be utilized to generate oxygen free radicals, hydrogen peroxide and oxygen molecules from ozone bubbled directly into the treatment tank for removal of organic materials on wafer 14 during operation of the ozonated water process of the invention.

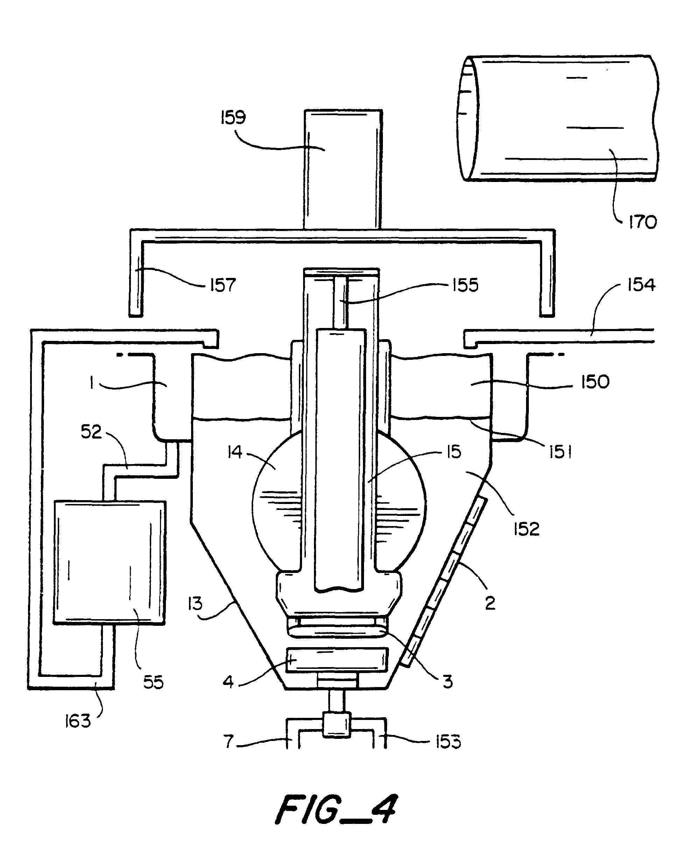

In a further embodiment, the tank is fitted with a lid 157 shown in figure 4 for closing the tank which has an infrared light source 159 mounted in the lid. The infrared light may be used to aid in drying the wafers after treatment. The infrared light source is disposed in the lid such that the light source is above the fluid in the tank when the lid is closed and is directed downward into the fluid.

The present invention is directed to a wafer drying process and apparatus. At the outset of the drying process of the present invention, the wafer preferably is entirely submerged in an aqueous rinsing bath (final rinsing bath) contained in a tank which is preferably hydraulically full with the rinsing bath.

The rinsing bath can be any type of aqueous based rinse typically used after the wet processing of semiconductor wafers. The preferred rinsing fluid is water. However, depending on the nature of the surface of the wafer to be rinsed, the nature of the contamination present on the surface, and the nature of process chemicals (e.g., cleaning or etching fluids) to be rinsed, other rinsing fluids may be employed. Other rinsing fluids which may employed include organic solvents, mixtures of organic solvents and water, mixtures of organic solvents, and the like. It is preferred that the rinsing fluid be water which has been deionized and filtered to remove dissolved and suspended matter.

It is also preferred that the rinsing fluid contact the wafers as a single phase, such as a liquid, and be substantially free of phase boundaries, such as gas/liquid interfaces, which occur when gas bubbles are present in a liquid. Particles can agglomerate at the gas-liquid phase boundary. These particulates may adhere to the surface of the wafer. Hydrophobic partides tend to collect at such interfaces, and they are thus undesirable. However, adherence of the particulate to the surface of the wafer is also a function of the composition of the wafer surface. A hydrophilic wafer surface such as silicon dioxide will have little affinity for hydrophobic particles, whereas hydrophobic surfaces such as bare silicon will attract hydrophobic particles.

In one embodiment of the present invention, a tank such as that depicted in Figure 4 is used for accomplishing the process of the present invention. The tank of Figure 4 is similar to that of Figure 2, except the tank of Figure 4 has extra equipment to facilitate the drying process. The preferred apparatus for treatment and drying of semiconductor wafers with a fluid includes a tank for use in a hooded, exhausted wet station. The tank 13 generally will have means connected to the tank for providing fluid into the tank 7, means 15 for supporting at least one wafer within the tank in contact with the fluid, means for draining 153, means for introducing the upper layer of organic drying solvent 154, and an over-flow weir 1.

The means for supporting at least one wafer within the tank 15 in contact with the fluid 152 can be any means known to those of skill in the art for placing a wafer in contact with a treatment solution as described above.

The means 154 for introducing organic solvent to the upper region of the tank generally will be a conduit connected to an upper section of the tank, but any device or apparatus known to those of ordinary skill in the art for providing a flow of fluid to a tank may be utilized. Fluid can be provided to the tank 13, for example, by perfluoroalkoxylvinylether (PFA) tubes or pipes, polytetrafluoroethylene (PTFE) tubes or pipes, polyvinylidene fluoride (PVDF) tubes or pipes, or quartz tubes. Preferably, PFA tubes or pipes are utilized. In a preferred embodiment, PFA tubes are connected to the tank with a flared fitting connection.

Drain means 153 is generally any means known to those of ordinary skill in the art for removing fluid from a tank. According to one embodiment of the present invention drain means 153 is located at the bottom of the tank 13 and includes a means for controlling the volume of liquid drained from the tank. The means for controlling the volume of liquid drained from the tank can be a simple valve arrangement or any other device known to those of ordinary skill in the art.

It should be appreciated that overflow weir 1 as depicted in figure 4 is a single trench design that wraps around the upper open face of the tank 13. In one embodiment, overflow weir 1 is equipped with trench draining means 52 which can be any type of drain known to those of ordinary skill in the art and optionally includes a valve. Trench draining means 52 is in fluid communication with organic drying solvent collection means 55 which may be any means of safely containing organic solvents known to those of ordinary skill in the art. Preferably, a drying solvent collection means 55 is employed. Solvent collection means 55 can be a reclaim canister that feeds from the bottom through organic solvent feeding moans 163. Organic solvent feeding means 163 can be used as an alternative source of organic drying solvent over the means for introducing organic solvent 154 once the reclaim canister has been charged with organic drying solvent.

A reclaim canister that feeds from the bottom is preferred because it will eliminate water buildup in the canister. In the process of overflowing some of the organic drying solvent from the tank, fluid from the rinsing bath may enter the overflow weir and ultimately enter the solvent reclaim canister. During the idle period, the rinsing bath and the organic drying solvent in the redaim canister will settle and form two layers in the canister. The aqueous rinsing bath will settle in the bottom of the reclaim canister and the organic drying solvent will settle on top of the rinsing bath. If on the next drying cycle the solvent is dispensed from the top of the reclaim canister (like a syringe), some water could remain behind in the reclaim canister. Over many uses, water may eventually replace the solvent in the reclaim canister and the dryer may fail. In order to prevent water buildup in the canister, the fluid is drawn from the bottom through organic solvent feeding means 163. This ensures that all of the water is expelled from the reclaim canister after each cycle. Accordingly, the solvent is plumbed to the tank such that the solvent is fed from the bottom of the reclaim canister through organic solvent feeding means 163 but returns from overflow weir 1 to the top of the reclaim canister via trench draining means 52.

As set forth above, the wafer should be fully submerged in the final rinsing bath 152. In one embodiment of the present invention, the wafer sits submerged in a hydraulically full tank which is filled with the aqueous rinsing bath. The aqueous rinsing fluid 152 is then drained to provide for the addition of the organic drying solvent. Typically, a minimum of 0.5 inches or more is drained by drain means 153. However, the top of the wafer should continue to be entirely submerged in the rinsing fluid 152.

At this point, the organic drying solvent 150 is then introduced at the top of the tank by means for introducing an organic solvent 154. The level of organic drying solvent sufficient to dry the wafer will vary depending upon the solvent, the speed with which the wafers are withdrawn from the bath, the temperature of the bath and the pressure over the bath. Typically a minimum of 0.5 inches of solvent is required. The faster the wafer is withdrawn from the bath, the deeper the organic drying solvent layer should be. The layer will vary from a thickness of 10 mm for a 10 second or longer wafer transfer time to a 18 mm thickness for a 2-4 second wafer transfer time. The volume of drying fluid added should correspond to the volume of rinsing fluid drained such that the tank remains hydraulically full reaching the top of tank 13.

In one embodiment, the draining and filling occurs simultaneously such that the tank is always hydraulically full and the level of total fluid in the tank remains constant. As known to those of ordinary skill in the art, mixing of organic and aqueous solutions gives a final volume different from the total volume of the unmixed components. Appropriate compensation for this should be provided.

In order to separate the organic drying solvent from the rinse water without additional extraction equipment or solvent recovery/distillation systems, the phase boundary is essential. The solvent is preferably immiscible with the aqueous rinsing bath and floats on the surface of the aqueous rinsing bath. Preferably solvents with solubilities less than 0.1 g/l in water are employed. The density of the organic drying solvent must be less than the density of the aqueous rinsing bath. Accordingly, if the density of the aqueous rinsing bath is 1, the density of the organic drying solvent must be less than 1.

In order to reduce the volatile organic compound emissions (VOC Emissions) of the drying process, the solvent also preferably has a low vapor pressure. If the solvent has a high rate of evaporation, not only does it require replenishing, but it requires abatement equipment to capture the gas and either burn it up or condense and recycle the gas. In either event, the desired solvent will preferably remain a liquid at room temperature and have low evaporation rates. The goal is to minimize solvent losses during processing (including volatile and liquid emissions). A dryer with an emission of less than 0.5 Ibs per day is preferred.

Another important criteria in selecting a solvent is safety. For example, the solvent is preferably not a carcinogen. Accordingly, alcohols and aliphatics may be preferred over aromatics such as benzene.

In addition to the criteria set forth above, the specific wafer processing should also be taken into consideration when selecting a solvent.

When the next wafer processing step subsequent to drying is a high temperature diffusion step, it may be preferable to leave a small organic layer on the surface of the wafer because it will act as a protection boundary for the underlying substrate and is easily removed in the diffusion furnace at low temperatures (200-400°C) prior to high temperature deposition of films (800-1600°C). Accordingly, when the next wafer processing step is a high temperature diffusion step, the solvent need only meet the criteria set forth above. Specifically, the solvent should provide for a good phase boundary with the aqueous rinsing bath and low VOC emissions.

When the next wafer processing step subsequent to drying is a low temperature CVD deposition, the presence of trace amounts of organics on the surface of the wafer can be detrimental. It can form unwanted side reactions such as silicon carbide, leave a haze on the wafers in a polysilicon deposition, or have metal films peel off the wafer such as tungsten silicide due to the organic interference. In low temperature CVD depostion, it is therefore preferable to remove all organics from the wafer surfaces. This can be accomplished by pulling the wafers through the solvent layer to displace the water and then exposing the wafers to a gaseous zone of ozone, a UV light and infrared heat. This oxidizes any trace of residual organic contamination. Accodingly, when the next wafer processing step is a low temperature CVD deposition, it is preferable to use an organic drying solvent which is comprised of a branched or oxygenated compounds such as ethers and ketones because they break down faster in ozone than straight chain hydrocarbons. Therefore, both straight chain and branched hydrocarbons (aliphatic hydrocarbons, ketones, and ethers) are preferred over aromatic compounds and hydrocarbons which contain nitrogen, sulfur or halogens.

The oxidation process can be accomplished without taking up additional wet station space by simply plumbing a tunnel between the last chemical bath and the unload station with ozone gas. The duration of the period in which the wafer is in the tunnel can be controlled in order to ensure the wafer is adequately exposed to the oxidation gases to achieve complete removal of organic residue (usually between two and three minutes). If an oxide free surface is desired, an additional gas step can be added in which anhydrous HF gas is fed at the end of the tunnel so that the wafers are bathed in the HF gas. The HF gas is fed at the end of the tunnel and the wafers are bathed in the HF gas for 15 seconds, prior to placement in the outgoing cassettes.

In view of the above, solvent selection and subsequent treatment can produce three different surface states; an organic protective layer, an organic free-silicon dioxide surface (hydrophilic), or an organic free silicon surface (hydrophobic).

Examples of preferred organic solvents according to the present invention include octane, decane, 5hepten-2-one and 2-nonanone. When a protective coating is desired, aliphatics are preferred. When a carbon free surface is desired, oxygenated ketones are preferred. The organic drying solvent according to the present invention may also be a single component or multi-component solvent. Solvents with vapor pressures less than 100 pascals at room temperature are preferred. Insoluble branched hydrocarbons with greater than a five carbon chain and a density less than water are preferred. The solvent need not have a minimum boiling azeotrope with water. Solvents with boiling points from 140 to 200°C are preferred.

After the organic drying solvent has been added, two phases exist in the bath. The lower aqueous phase 152 is comprised of the rinsing bath remaining in the tank after the partial draining set forth above. The upper organic phase 154 is comprised of the organic drying solvent.

The wafer is then lifted up out of the lower aqueous layer 152 and through the upper organic layer 150, thus driving off rinsing fluid from the surface of the wafer at the interface of the upper and Lower layers 151. The present invention does not use solvent vapors to accomplish drying. Although other mechanisms may be at work, it is believed that the phase interface between the organic drying solvent and the aqueous rinsing bath facilitates drying by displacing water. Organic solvents have little affinity for silicon and hence are pulled virtually dry. Surface tension may also be a secondary effect in this drying technology.

In one embodiment of the present invention the tank apparatus includes a lifting means 155 for the removal of end effector 15 which holds the wafers. Lifting means 155 can be two vertical lifts (one located on each side of the tank and connected to end plates on each side of the end effector). The wafers can then be transferred to a horizontal robot and travel to an unload station.

The lifting means 155 can be any number of a variety of lifting methods known to those of ordinary skill in the art of wafer handling. One such means is disclosed in U.S. Patent No. 4,722,752. The lifting means can also be a manual lifting means wherein a handle is attached to the end effector. However, the system is preferably robotic.

In one embodiment of the present invention, when the wafers have cleared the liquid level, water is introduced from the bottom of the tank through a deionized water inlet to overflow a small volume in excess of the volume of organic drying solvent added into over-flow weir 1.

Once the wafers have cleared the liquid level, the drying solvent remaining on the wafers evaporates. The evaporation process may be expedited by heating or any of the above mentioned post treatments including exposure of the wafer to ozone gas, UV, IR and/or HF. However, once the wafer has cleared the liquid, there is no water remaining on the surface of the wafer. Accordingly, the evaporation occurring is evaporation of the organic drying solvent and not the evaporation of water because all of the water has been driven off the surface of the wafer.

In a preferred embodiment, the IR light described above is used in conjunction with the solvent drying process wherein an appropriate hydrocarbon solvent is introduced on the top of the fluid in the tank and the wafers are slowly lifted through the solvent layer so that the solvent layer displaces the water from the wafers. Any solvent remaining on the wafers is vaporized by the process of heating the wafers using the IR lamp to about 150°C ± 30°C and introducing ozone gas to oxidize the organic remnants. The IR light can either be mounted to the outside of lid 157 (preferably of quartz) or mounted to the outside of gas tunnel 170 through which the wafers travel after removal from the tank.

## Claims

1. A process for drying one or more semiconductor wafers (14) submerged in an aqueous rinsing bath, **characterized by**:
adding an organic drying solvent (150) with a density less than water to said bath to form a lower aqueous layer (152) and an upper liquid organic layer (150) in said bath, liquid said organic drying solvent being immiscible with the aquous rinsing bath, said wafer (14) remaining entirely submerged in said lower aqueous layer (152), and;
lifting said water (14) from said lower aqueous layer (152) up through said upper liquid, organic layer (150).

2. The process of claim 1, further comprising removing said wafer (14) from said bath and completing said drying step outside of said bath.

3. The process of claim 1, further comprising one or more wet processing steps preceding said adding step.

4. The process of claim 1, further comprising a step of evaporation drying wherein a stream of ozone is passed over a surface of said wafer (14).

5. The process of claim 1, further comprising a step of evaporating organic drying solvent (150) remaining on the surface of the wafer (14) wherein said evaporation is accelerated by exposing said wafer to an IR light source.

6. The process of claim 1, wherein said organic drying solvent is an insoluble branched hydrocarbon with greater than a five carbon chain, with a density less than water.

7. The process of claim 6, wherein said organic drying solvent is decane or 2-nonanone.

8. The process of claim 1, wherein said lower aqueous layer (152) is deionized water.

9. A process for the drying of a plurality of semiconductor, wafers (14) submerged in an aqueous rinsing according to any of claims 1 to 8, **characterized in that** a top portion of said aqueous rinsing bath is replaced with the immiscible liquid organic drying solvent.

## Patentansprüche

1. Verfahren zur Trocknung einer oder mehrerer
Halbleiterscheiben (14), die in ein wäßriges Spülbad eingetaucht sind, **gekennzeichnet durch**:
Hinzusetzen eines organischen Trocknungslösungsmittels (150) mit einer geringeren Dichte als Wasser zu dem Bad, um eine untere wäßrige Schicht (152) und eine obere flüssige, organische Schicht (150) in dem Bad auszubilden, wobei das Trocknungslösungsmittel unvermischbar mit dem wäßrigen Spülbad ist, und wobei die Scheibe (14) gänzlich in der unteren wäßrigen Schicht (152) eingetaucht bleibt; und
Heben der Scheibe (14) aus der unteren wäßrigen Schicht (152) **durch** die obere flüssige, organische Schicht (150).

2. Verfahren nach Anspruch 1, ferner mit dem Schritt: Entfernen der Scheibe (14) aus dem Bad und Beenden des Trocknungsschritts außerhalb des Bades.

3. Verfahren nach Anspruch 1, ferner mit einem oder mehreren Naßbehandlungsschritten, die dem Schritt des Hinzusetzens vorausgehen.

4. Verfahren nach Anspruch 1, ferner mit einem Verdampfungstrocknungsschritt, wobei ein Ozonstrom über die Oberfläche der Scheibe (14) geführt wird.

5. Verfahren nach Anspruch 1, ferner mit einem Verdampfungsschritt eines organischen Trocknungslösungsmittels (150), das auf der Oberfläche der Scheibe (14) verbleibt, wobei die Verdampfung dadurch beschleunigt wird, daß die Scheibe einer IR-Lichtquelle ausgesetzt wird.

6. Verfahren nach Anspruch 1, wobei das organische Trocknungslösungsmittel ein unlöslicher verzweigter Kohlenwasserstoff mit einer Kette mit mehr als fünf Kohlenstoffatomen und mit einer geringeren Dichte als Wasser ist.

7. Verfahren nach Anspruch 6, wobei das organische Trocknungslösungsmittel ein Dekan oder 2-Nonanon ist.

8. Verfahren nach Anspruch 1, wobei die untere wäßrige Schicht (152) deionisiertes Wasser ist.

9. Verfahren zur Trocknung mehrerer Halbleiterscheiben (14), die in ein wäßriges Spülbad getaucht sind, nach einem der Ansprüche 1 bis 8, **dadurch gekennzeichnet, daß** ein oberer Abschnitt des wäßrigen Spülbades durch das unvermischbare flüssige organische Trocknungslösungsmittel ersetzt wird.

## Revendications

1. Procédé de séchage d'une ou plusieurs tranches de semiconducteur (14) immergées dans un bain de rinçage aqueux, **caractérisé par** les étapes consistant à :
ajouter un solvant de séchage organique (150) ayant une densité inférieure à celle de l'eau pour former une couche aqueuse inférieure (152) et une couche organique supérieure (150) dans ledit bain, ledit solvant de séchage organique étant non miscible dans ledit bain de rinçage aqueux, ladite tranche (14) restant entièrement immergée dans ladite couche aqueuse inférieure (152), et ;
soulever ladite tranche (14) de ladite couche aqueuse inférieure (152) jusqu'à ce qu'elle traverse ladite couche organique liquide supérieure (150).

2. Procédé selon la revendication 1, comprenant en outre l'étape consistant à retirer ladite tranche (14) dudit bain et à achever ladite étape de séchage en dehors dudit bain.

3. Procédé selon la revendication 1, comprenant en outre une ou plusieurs étapes de traitement par voie humide précédant ladite étape d'addition.

4. Procédé selon la revendication 1, comprenant en outre une étape de séchage par évaporation dans laquelle un courant d'ozone est amené à passer au-dessus d'une surface de ladite tranche (14).

5. Procédé selon la revendication 1, comprenant en outre une étape consistant à évaporer un solvant de séchage organique (150) restant à la surface de la tranche (14) dans laquelle ladite évaporation est accélérée en exposant ladite tranche à une source de lumière infrarouge.

6. Procédé selon la revendication 1, dans lequel ledit solvant de séchage organique est un hydrocarbure ramifié insoluble ayant une chaîne de plus de cinq atomes de carbone, et présentant une densité inférieure à celle de l'eau.

7. Procédé selon la revendication 6, dans lequel ledit solvant de séchage organique est du décane ou de la 2-nonanone.

8. Procédé selon la revendication 1, dans lequel ladite couche aqueuse inférieure (152) est de l'eau déminéralisée.

9. Procédé de séchage d'une pluralité de tranches de semiconducteur (14) immergées dans un bain de rinçage aqueux selon l'une quelconque des revendications 1 à 8, **caractérisé en ce qu'**une partie supérieure dudit bain de rinçage aqueux est remplacée par le solvant de séchage organique liquide non miscible.
